Europäisches Patentamt

European Patent Office

Office européen des brevets

(11) Veröffentlichungsnummer: **0 264 840**
**A2**

(12) **EUROPÄISCHE PATENTANMELDUNG**

(21) Anmeldenummer: 87115125.4

(22) Anmeldetag: 16.10.87

(51) Int. Cl.⁴: **H05K 3/30**

(30) Priorität: 23.10.86 DE 3636065

(43) Veröffentlichungstag der Anmeldung:
27.04.88 Patentblatt 88/17

(84) Benannte Vertragsstaaten:
AT BE CH DE FR GB LI

(71) Anmelder: **Lorenzen, Klaus**
**Robert-Bosch-Strasse 18**
**D-7160 Gaildorf 3(DE)**

(72) Erfinder: **Lorenzen, Klaus**
**Robert-Bosch-Strasse 18**
**D-7160 Gaildorf 3(DE)**

(74) Vertreter: **Otte, Peter, Dipl.-Ing.**
**Tiroler Strasse 15**
**D-7250 Leonberg(DE)**

(54) Verfahren und Vorrichtung zur Lagerung von elektrischen Bauelementen auf einer Leiterplatte.

(57) Bei einem Verfahren und einer Vorrichtung zur Lagerung von elektrischen Bauteilen, die Spulen, Entstördrosseln, Übertrager, Transistoren, Kondensatoren o.dgl. sein können, auf einer Leiterplatte, wird vorgeschlagen, das Trägergehäuse für das elektrische Bauelement zweiteilig auszubilden und einen unteren Teil unmittelbar mit der Printplatte zu verrasten, während ein oberes Gehäuseteil als Bauelementträger in zwei verschiedenen Rastpositionen mit dem unteren Gehäuseteil gebracht werden kann. In der ersten, auseinandergezogenen Rastposition der beiden Gehäuseteile können am unteren Gehäuseteil befindliche Rastbeinchen mit Durchtritten in der Printplatte verrastet werden, gegebenenfalls durch eine zusätzliche Drehbewegung, während in der zusammengedrückten Position vom oberen Gehäuseteil ausgehende Verriegelungsstege diese Rastbeinchen hintergreifen oder seitlich festlegen und gegebenenfalls gleichzeitig vom elektrischen Bauelement herrührende elektrische Anschlußdrähte durch das Zusammendrücken der Gehäuseteile durch entsprechende Durchtrittsöffnungen in der Printplatte, über Drahtführungshülsen am Gehäuse geführt werden.

Fig. 5

## Verfahren und Vorrichtung zur Lagerung von elektrischen Bauelementen auf einer Leiterplatte

Stand der Technik

Die Erfindung geht aus von einem Verfahren nach der Gattung des Hauptanspruchs und einer Vorrichtung nach der Gattung des Anspruchs 4 . Als bekannt vorbeschrieben sind solche Möglichkeiten zur Lagerung elektrischer Bauelemente auf Print-oder Leiterplatten in den Patentanmeldungen P 36 13 863.0, P 36 13 862.2 oder P 36 13 861.4.

Allgemein können elektrische Bauelemente beliebiger Art auf Leiter-oder Printplatten oder auf sonstigen großflächigen Unterlagen dadurch befestigt werden, daß sie mit ihrem Gehäuse auf die Leiterplatte aufgesetzt und am Gehäuse beispielsweise Befestigungsflansche angeordnet sind, durch welche Befestigungsmittel, etwa Schrauben o.dgl. geführt sind, mit denen die Elemente an der Leiterplatte festgeschraubt werden können. Es ist auch bekannt, elektrische Bauelemente unmittelbar auf die Leiterplatte aufzusetzen und die üblicherweise beiden Anschlußleitungsstücke durch Bohrungen in der Leiterplatte zu führen und auf der anderen Seite zu verlöten; dies wird häufig bei Widerständen, Transistoren in diskreter Bauelementform u.dgl. vorgenommen, weil die Anschlußdrähtchen hinreichend stark sind, um die geringe Masse eines solchen Bauelementes zu tragen und auch gegen Erschütterungen zu sichern.

Größere Bauelemente erfordern demgegenüber eine gesonderte Befestigung, die beispielsweise auch so ausgebildet sein kann, daß, wie auch in den vorgenannten Anmeldungen erläutert, entsprechende, solche Bauelemente aufnehmende oder tragende Gehäuse mit Rastbeinchen versehen sind, die mit einer unteren, ausgeprägten Nasenform durch entsprechende Öffnungen in der Leiterplatte gesteckt werden, in welcher sie dann durch Hintergreifen mit dem nasenartigen Vorsprung festgeklemmt und insofern auch formschlüssig befestigt sind. Allerdings ist nicht ausgeschlossen, daß bei solchen über Rastnasen in Ausnehmungen der Trägerplatte sozusagen eingeklipsten und verrasteten Bauelemente, insbesondere wenn es sich um große und schwere Bauelemente wie Trafos, Kondensatoren, Relais, Entstördrossel u.dgl. handelt und die Printplatten andererseits zusammen mit dem mit ihnen ausgerüsteten Gerät beim Betrieb Bewegungen, Schwingungen oder Vibrationen unterworfen sind, Probleme auftreten, weil die Rastbeinchen die Bauelemente lediglich durch ihre Vorspannung halten und bei entsprechenden Querbeschleunigungen auch aus den notwendigerweise für den ursprünglichen Durchtritt größer bemessenen Öffnungen der Printplatte wieder austreten können.

Bei den bekannten Befestigungseinrichtungen für elektrische Bauelemente ist daher auch schon vorgeschlagen worden (P 36 13 836.0), angrenzend zu diesen Rastnasen aufweisenden Rastbeinchen Fixierbeine anzuordnen, die mindestens eine weitere Anschlagfläche für die Trägerplattendurchbrechung bilden derart, daß nach dem Einrasten der für das Zurückweichen und Verriegeln der Rastnasen erforderliche Durchbrechungsfreiraum aufgenommen ist und das gesamte Verriegelungsmittel so bündig an den Trägerplattendurchbrechungen anliegt.

Hierdurch kann sich allerdings die Bauform der die elektrischen Bauelemente tragenden Gehäuse im Bereich der Befestigungs-und Verrastungsmittel nicht unerheblich verkomplizieren; außerdem muß zwischen dem Rastbein und dem zugeordneten Fixierbein immer noch ein Abstand aufrechterhalten bleiben, der das anfängliche Abbiegen des Rastbeins ermöglicht, damit dessen Rastnase ebenfalls durch die Leiterplattendurchbrechung geführt werden kann, die sie später auf der Rückseite hintergreift.

Kommt man hingegen nochmals auf die einfache Rastbeinchenverriegelung zurück, die beispielsweise bei einem im Querschnitt runden Bauelement Rastbeinchen jeweils um 90° oder auch nur 120° verteilt mit nach außen gerichteten Rastnasen aufweisen kann, so muß der Öffnungsquerschnitt in der Leiterplatte zur Aufnahme des jeweiligen Rastbeinchens mit senkrecht zur Einführungsrichtung vorspringenden, also in Querrichtung weisenden Rastnase mindestens so groß sein, daß der die Rastnase tragende Kopf des jeweiligen Rastbeinchens hindurchtreten kann. Nach Hintergreifen der Trägerplattenrückfläche bleibt dann notwendigerweise immer ein Abstandsspalt, der so groß ist wie der von der Rastnase in Querrichtung gebildete Vorsprung, denn sonst könnte das jeweilige Rastbeinchen durch die entsprechende Aufnahmeöffnung nicht hindurchgeführt werden. Dies bedeutet aber bei dieser üblichen Rastbeinchenbefestigung, daß das Bauelement notwendigerweise locker in seiner Halterung sitzt, unter Umständen auch dann, wenn wie erwähnt, mehrere Rastbeinchen mit Rastnasen vorhanden sind, die in unterschiedliche Richtungen weisen. Auch bei einer entsprechenden Vorspannung der Rastbeinchen, die eine Außenanlage nach Hintergreifung ermöglichen, können stärkere, in Querrichtung wirkende Beschleunigungseinwirkungen eine solche Lagerung mit ihrem Bauelement so weit - schrägziehen und in den verbleibenden Toleranzen der Aufnahmeschlitze so verkanten, daß gegebenenfalls ein oder mehrere der Rastbeinchen aushängen, woraufhin dann bei einer einwirkenden Beschleunigung in einer anderen Richtung alle Rastbeinchen ihren Halt verlieren können. Das jeweilige elektrische Bauelement, beispielsweise ein durch seinen Gehalt an schwerem Eisen stets vergleichsweise schwerer Übertrager oder eine Entstördrossel, aber auch ein Kondensator kommen dann von der Trägerplatte los, was nicht nur erhebliche Beschädigungen ergibt, sondern auf jeden Fall auch die Zerstörung der entsprechenden elektrischen Funktionen des Geräts.

Ferner ist es bei den bekannten Befestigungsmitteln für elektrische Bauelemente an Printplatten nicht möglich, gleichzeitig mit einer solchen Befestigungsart die elektrische Verbindung herzustellen oder doch mindestens vorbereitend zu sichern; so müssen beispielsweise bei der Anordnung von Übertragern, Entstördrosseln oder Kondensatoren zusätzlich noch mit den normalerweise relativ dünnen Anschlußdrähtchen etwa der Wicklungen des Übertragers oder einer Drossel Lötstifte verbunden werden, die dann in geeigneten Ausnehmungen des Gehäuses sitzen und sich soweit in Richtung auf die Leiterplatte erstrecken, daß beim Befestigen des Gehäuses diese Lötstifte durch eigene Leiterplattenbohrungen geführt werden können, so daß ein Verlöten auf der Rückseite, also auf der Leiterseite möglich ist. Hier kann man unter Umständen auch ohne solche gesonderten Lötstifte auskommen, wenn die Anschlußdrähte relativ dick sind; sie müssen dann aber trotzdem umständlich durch die zugeordneten Löcher gefädelt, jedenfalls auf diese ausgerichtet werden, wobei sich bei der Montage nicht selten beim Festdrücken der Rastbeinchen der jeweilige elektrische Anschlußstift, also Lötstift oder Anschlußdraht dennoch in seiner Durchführungsöffnung verkantet, nach oben drückt, aus seiner Lagerung gelangt, gegebenenfalls auch abreißt.

Dies alles sind Nachteile, die nur schwierig und mit erheblichem Aufwand bewältigt werden können und die natürlich insbesondere dort als besonders problematisch auftreten, wo das jeweilige elektrische Bauelement, welches auf der Grundplatte zu befestigen ist, selbst relativ schwer ist, also nicht von seinen eigenen elektrischen Anschlußleitungen gehalten werden kann, wie dies bei den schon erwähnten Spulen, Kondensatoren, Relais, Drosseln u.dgl. der Fall ist.

Demnach liegt der vorliegenden Erfindung die Aufgabe zugrunde, ein Verfahren und eine Vorrichtung zur Lagerung oder Befestigung von elektrischen Bauelementen auf einer Leiter-oder Printplatte zu schaffen, wobei die für sich gesehen bekannte Befestigungsart des das elektrische Bauelement tragenden oder aufnehmenden Gehäuses über Rastbeinchen beibehalten wird, andererseits aber dafür gesorgt wird, daß die Rastbeinchen keinesfalls wieder aushängen können,und/oder mit gleichen Mitteln die Möglichkeit geschaffen wird, daß sich die entsprechenden Anschlußdrähtchen des elektrischen Bauelementes sozusagen automatisch und sicher ausgerichtet in ihre zugeordneten Öffnungen der Printplatte einfädeln. Beide Ziele, also sichere Verriegelung und prob lemloses Einfädeln der Anschlußdrähte, können durch vorliegende Erfindung auch gemeinsam erreicht werden.

Vorteile der Erfindung

Das erfindungsgemäße Verfahren und die erfindungsgemäße Vorrichtung lösen diese Aufgabe mit den kennzeichnenden Merkmalen des Hauptanspruchs bzw. des Anspruchs 4 und haben den Vorteil, daß durch die Aufteilung des das elektrische Bauelement aufnehmenden oder tragenden Gehäuses in zwei zueinander relativ bewegliche Teilgehäuse nach dem Einklipsen in die Trägerplatte durch die Verrastungsmittel erster Art am Gehäuse Rastmittel zweiter Art eine Veränderung der Gehäusestruktur ermöglichen, indem im bevorzugten Anwendungsfall die beiden Gehäuseteile aus einer ersten Rastposition (Lieferzustand) in eine zweite Rastposition (eingebauter Endzustand) zusammengedrückt und so in ihrer Außenform geändert werden können, daß die beiden Gehäsueteile zunächst fest miteinander verbunden sind bzw. bleiben, gleichzeitig aber durch formschlüssige Anlage und Hintergreifung der Rastbeinchen deren unbedingte Anlage in der Rastposition fixiert und aufrechterhalten wird. Das Bauelement ist auf diese Weise vollkommen rüttelfest und sicher auf der Leiterplatte verankert und kann nicht mehr gelöst werden.

Gleichzeitig ist es möglich, durch diesen Vorgang das problemlose Einfädeln und Durchführen der Anschlußdrähte (unter Verzicht auf gesonderte Lötstifte) durch zugeordnete Öffnungen in der Leiterplatte vorzunehmen, so daß nach dem Zusammendrücken der beiden Gehäuseteile die Anschlußdrähte um ein vorgegebenes Stück auf der Leiterplattenrückseite, also der die Leitungen tragenden Seite herausragen bzw. jedenfalls so positioniert sind, daß ein einfaches Verlöten auf dieser Seite möglich ist. Diese Maßnahme kann allein oder zusätzlich zu der formschlüssigen Verriegelung der Rastbeinchen getroffen werden, so daß die Erfindung sowohl in der alleinigen Anwendung der Rastbeinchenverriegelung, in der problemlosen Einführung und Durchfädelung der Anschlußdrähte als auch in der Kombination der beiden Maßnahmen gleichzeitig gesehen wird, wobei die Kombination natürlich am vorteilhaftesten ist und mehrere Probleme und Schwierigkeiten mit einem Schlage zu lösen imstande ist.

Dabei ist von Vorteil, daß das erfindungsgemäße, das jeweilige auf der Leiterplatte zu befestigende oder anzuordnende elektrische Bauelement tragende oder aufnehmende Gehäuse von einfacher Bauart sein kann und lediglich über Verrastungsmittel erster Art, nämlich die für sich gesehen schon bekannten üblichen Rastbeinchen zur Befestigung an der Leiterplatte, sowie über Rastmittel zweiter Art verfügt, mit welchen die Gehäusedimensionsänderung möglich ist zur Erzielung der formschlüssigen Abstützung der Rastbeinchen in ihrer Aufnahmeposition in den Durchbrechungen der Leiterplatte und/oder zum Einfädeln der Anschlußdrähte in die Durchführungen der Leiterplatte.

Durch die in den Unteransprüchen aufgeführten Maßnahmen sind vorteilhafte Weiterbildungen und Verbesserungen der Erfindung möglich. Besonders vorteilhaft ist die Ausbildung von trichterförmig verlaufenden Aufnahmekanälen für die Anschlußdrähte in dem unteren, insofern der Leiterplatte näheren Gehäuseteil, welches im folgenden auch als Grundträger bezeichnet wird. Durch diese trichterförmige Einfädelungshilfe werden die Anschlußdrähte genau über ihre zugeordneten, im vorgegebenen Rasterabstand auf der Leiterplatte angeordneten Durchbohrungen gerichtet, durch welche sie dann beim Zusammendrücken des Gehäuses auch eintreten. Hier können noch zusätzliche, ineinander verschiebbare Gleit-und Führungshülsen in beiden Gehäuseteilen, also im Grundträger und in dem im folgenden auch als sogenannten Bauelementträger bezeichneten Gehäuseteil vorgesehen sein, in denen die entsprechenden (verzinnten) Anschlußdrähte sitzen. Ein Ende der Führungshülsen liegt dann unmittelbar auf der Printplatte auf und richtet so den Anschlußdraht auf die zugeordnete Durchtrittsöffnung aus.

Vorteilhaft ist ferner, wenn der Enddurchmesser des Trichters etwas kleiner als der Bohrungsdurchmesser in der Printplatte oder Leiterplatte ist, so daß sich der Draht beim Ineinanderschieben der Drahtführungshülsen aus dem Trichter heraus ohne Blockieren durch die Printbohrung bis zur gewünschten Länge herausschieben läßt. Es gelingt so auch, Bauteile mit dünneren Drähten im Lieferzustand genau im Rastermaß und ohne die komplizierte und umständliche Anordnung von zusätzlichen Lötstiften unmittelbar an Leiterplatten zu befestigen und die dünnen Drähte in eine einem Lötvorgang zugänglichen Endzustand zu bringen.

Die Erfindung ermöglicht daher den völligen Wegfall von Lötstiften, die als Zwischenteil so ausgebildet sein mußten, daß sie einerseits fest mit dem Gehäuse verbunden waren, beispielsweise in diesem angespritzt waren, an ihrem oberen Ende mit dem dünnen Anschlußdraht des elektrischen Bauelements umwickelt waren, dort eine Verlötung erfolgen mußte, woraufhin dann der Lötstift beim Aufsetzen des Gehäuses bzw. des Bauelementes durch eine entsprechende Öffnung in der Printplatte gefädelt oder geführt werden mußte und dann die Verlötung auf der anderen Seite noch vorzunehmen war.

Im optimalen Anwendungsfall ermöglicht die Erfindung also bei völligem Wegfall der erwähnten Lötstifte die problemlose elektrische Kontaktierung auch dünner und dünnster Anschlußdrähte und die Verlötung mit den entsprechenden Kupferleitungen auf der Leiterplattenrückseite und gleichzeitig die absolut feste Verrastung und Fixierung des gesamten Bauelements auf der Leiterplatte.

Zeichnung

Ausführungsbeispiele der Erfindung sind in der Zeichnung dargestellt und werden in der nachfolgenden Beschreibung näher erläutert. Es zeigen:

Fig. 1 einen Schnitt längs der Linie I-I der Fig. 2 durch ein erstes Gehäuseteil (Grundträger) und

Fig. 2 das Gehäuseteil der Fig. 1 in Draufsicht von oben;

Fig. 3 einen Schnitt längs der Linie III-III der Fig. 4 des zweiten Gehäuseteils (Bauelementträger) und

Fig. 4 die Ansicht von unten auf das Gehäuseteil der Fig. 3;

Fig. 5 zeigt in einer Seitenansicht die beiden miteinander verbundenen Gehäuseteile Grundträger und Bauelementträger einmal in der Vorfixierposition (Lieferzustand) auf der linken Seite der mittleren Trennlinie und in der zusammengedrückten Position (fertig montierter Endzustand) auf der rechten Seite der Trennlinie;

Fig. 6a und 6b zeigen den Schnitt durch das beide Gehäuseteile umfassende Gehäuse zur Lagerung elektrischer Bauelemente entsprechend Fig. 5 einmal in der auseinandergezogenen ersten Rastposition (Fig. 6a) und in der zusammengedrückten zweiten Rastposition (Fig. 6b), wobei der Schnitt längs der Schnittlinie I-I bzw. III-III der Fig. 2 und 4 gelegt ist und

Fig. 7 zeigt eine weitere Ausführungsform einer Befestigungsvorrichtung für elektrische Bauelemente auf einer Leiterplatte, bei der die Drahtführungskanäle aus je zwei ineinandergreifenden und ineinander verschiebbaren Hülsen bestehen und die

Fig. 8a und 8b zeigen eine dritte Ausführungsform der Erfindung, bestehend aus einem zweiteiligen Gehäuse, jeweils schon befestigt auf der zugehörigen Print-oder Leiterplatte in der ersten Rastposition und in der zusammengedrückten zweiten Rastposition.

Beschreibung der Ausführungsbeispiele

Der Grundgedanke vorliegender Erfindung besteht darin, ein Lagergehäuse für elektrische Bauelemente auf Leiter-oder Printplaten zweiteilig so auszubilden, daß die beiden Teile zueinander zwei unterschiedliche Rastpositionen einnehmen können, wobei eine erste Rastposition eine eher auseinandergezogene Struktur des Gehäuses aufweist und einen Lieferzustand betrifft, während die zweite Rastposition eine zusammengedrückte Gehäusestruktur bildet, durch welche mehrere vorteilhafte Möglichkeiten und Maßnahmen zur Lösung von Problemen erzielt sind, die sich bei der Befestigung von elektrischen Bauelementen von Leiterplatten ergeben. So können durch die zusammengedrückte Gehäusestruktur gleichzeitig Verriegelungsschienen oder Stützhebel für die Rastbeinchen zur Verankerung des Gehäuses auf der Leiterplatte so ausgefahren werden, daß diese die Rastbeinchen formschlüssig hintergreifen und die Durchtrittsöffnung in der Leiterplatte vollkommen verschließen, wodurch ein späteres Lösen ausgeschlossen ist und/oder durch das Zusammenschieben können gleichzeitig Anschlußdrähte des elektrischen Bauelements mittels Längskanäle in entsprechend ausgerichtete Aufnahme-und Durchtrittsöffnungen der Leiterplatte so geführt werden, daß diese auf der anderen Seite zur nachfolgenden Verlötung erscheinen und austreten.

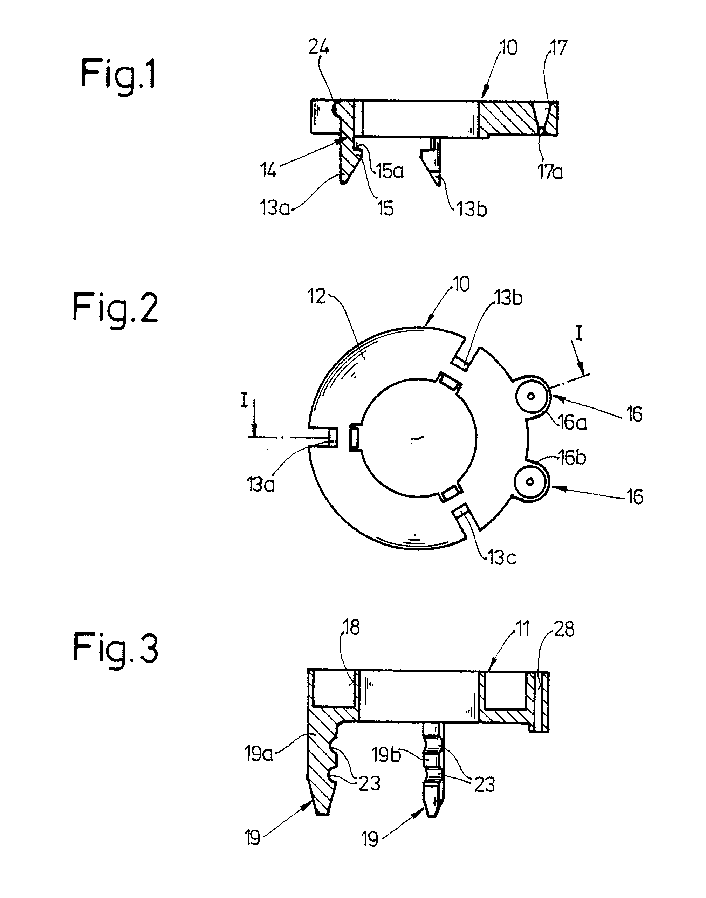

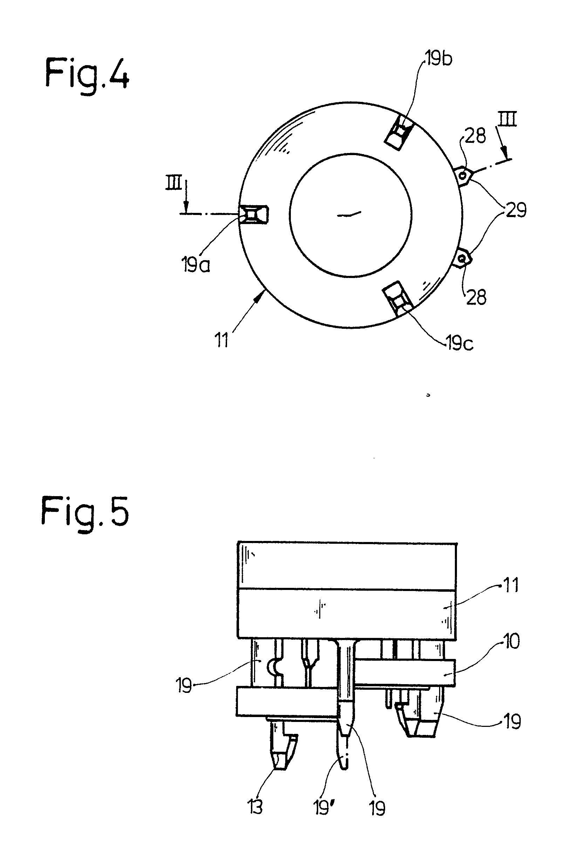

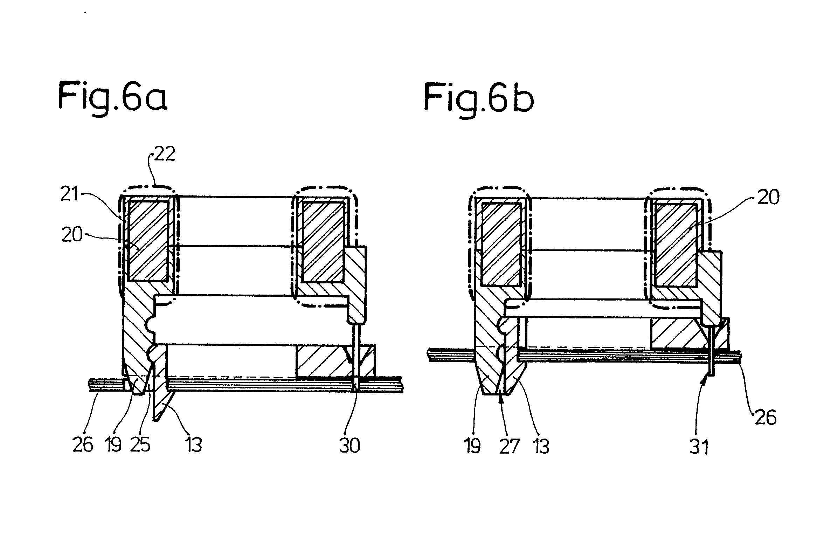

Bevor im folgenden auf spezielle Ausführungsformen der Erfindung eingegangen wird, sei darauf hingewiesen, daß diese lediglich beispielhaft zu verstehen sind und die Erfindung nicht, weder der Dimension noch der Anordnung der einzelnen Elemente nach, einschränken. Am besten läßt sich die Erfindung verstehen anhand der Darstellung der Fig. 6a und 6b in Verbindung mit den Fig. 1 bis 5, wobei die Fig. 1 und 2 ein erstes Gehäuseteil, nämlich den mit der Leiter-oder Printplatte zu verrastenden und verankernden Grundträger 10 und die Fig. 3 und 4 das zweite Gehäuseteil, nämlich den wiederum mit dem Grundträger in zwei verschiedenen Rastpositionen zu verrastenten Elementträger 11 darstellen.

Die Darstellung der Fig. 2 zeigt, daß der Grundträger 10 aus einem ringförmigen Hauptkörper 12 besteht, an dem, jedenfalls für die Erfüllung der weiter vorn erwähnten Funktionen, zwei unterschiedliche Komponentengruppen angeordnet sind, nämlich die Rastmittel erster Art, die mit 13 bezeichnet sind und in dem dargestellten Ausführungsbeispiel jeweils um 120° über den Umfang des Grundträgers versetzte drei Rastbeinchen 13a, 13b und 13c umfassen. Die Rastbeinchen 13a, 13b und 13c sind in üblicher Weise ausgebildet; sie sind vorzugsweise einstückige Teile des Grundkörpers 12 oder an diesen angeformt oder befestigt und umfassen einen sich senkrecht nach unten, also in Richtung auf die Print-oder Leiterplatte erstreckenden Arm 14 und eine zu diesem sich in Querrichtung erstreckende Rastnase 15, wobei das Ganze nach unten, also in Richtung auf die Durchbrechungen der Leiterplatte weisend verjüngend ausgebildet ist, so daß ein leichtes Einführen möglich ist. Mit der Abschulterung 15a der Rastnase hintergreift dann jedes Rastbeinchen 13a, 13b, 13c oder hintergreifen die Rastmittel 13 in der allgemeinen Ausführungsform die Rückseite oder hier Leiterseite der Printplatte, wenn man die Oberseite als Bauelementenseite bezeichnet.

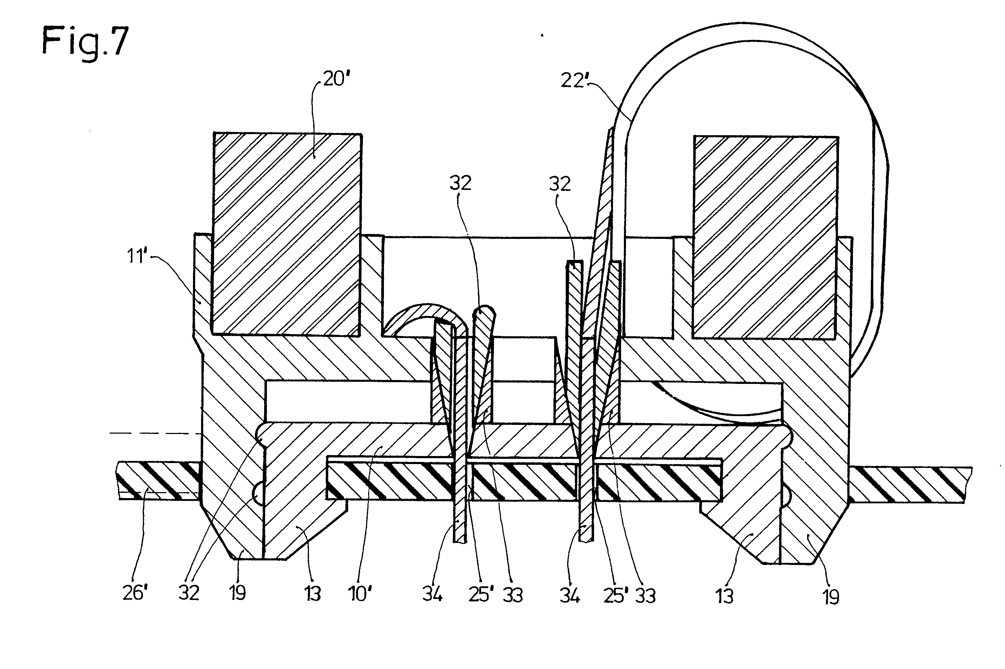

Der Grundträger 10 verfügt ferner über bei dem dargestellten Ausführungsbeispiel zwei Führungsmittel 16 für das Bereithalten, Einfädeln und Durchführen der elektrischen Anschlußdrähte des jeweiligen, vom Elementträger getragenen oder aufgenommenen elektrischen Bauelements, wobei bei diesem dargestellten Ausführungsbeispiel die Führungsmittel 16 aus zwei an den Hauptkörper 12 angesetzte, nach außen vorspringende Augen 16a, 16b gebildet sind, die, wie am besten die Darstellung der Fig. 1 zeigt, eine sich trichterförmig verjüngende Innenbohrung 17 jeweils aufweisen, die in eine Austrittsöffnung 17a mündet, deren Durchmesser vorzugsweise etwas geringer ist als der Durchmesser der Durchtrittsbohrungen für die elektrischen Leitungen in der Leiterplatte, so daß sich keine nach innen vorstehende Randkanten ergeben, gegen welche ein einzufädelnder elektrischer Leitungsanschluß anstoßen könnte. Diese wird noch genauer anhand der Darstellung der Fig. 7 erläutert.

Mit diesem ersten Gehäuseteil als Grundträger 10 verbunden ist ein zweites Gehäuseteil, nämlich der Elementträger 11 entsprechend den Fig. 3 und 4, wobei die Verbindung über Rastmittel zweiter Art getroffen ist, die mindestens zwei unterschiedliche relative Rastpositionen der beiden Gehäuseteile Grundträger 10 und Elementträger 11 zueinander ermöglichen.

Es versteht sich, daß der Elementträger wie der Grundträger an sich beliebig ausgebildet sein kann und daher auch der Form des mit der Leiterplatte zu verbindenden elektrischen Bauelemente angepaßt sein kann, wobei dann beide Gehäuseteile so ausgebildet sind, daß die Rastmittel erster Art ihre Aufgabe erfüllen können. Bei dem dargestellten Ausführungsbeispiel dient das Gehäuse der Aufnahme und Lagerung einer Drosselspule, beispielsweise einer Funkentstörspule, so daß im Bauelementträger 11 ein offener Ringkanal 18 gebildet ist, in den ein Ringkern eingelegt werden kann. Der Ringkanal 18 nimmt bei dem dargestellten Ausführungsbeispiel den Ringkern 20 (siehe Fig. 6a und 6b) lediglich zur Hälfte auf; der Aufbau des Bauelemententrägers vervollständigt sich daher in diesem Fall noch durch eine obere ringförmige Abdeckkappe 21, die den Ringkanal 18 mit eingelegtem Ringkern 20 nach oben verschließt. Hierdurch ergibt sich gleichzeitig auch eine elektrische Isolierung des Ringkerns 20 und die Drosselwicklung 22 wird dann, wie in den Fig. 6a und 6b angedeutet, um beide Teile und den innenliegenden Ringkern durchgeführt, so daß durch die Wicklung die beiden jeweils zur Hälfte einen Aufnahmeringkanal für den Ringkern bildenden Teile miteinander verbunden werden. Es' ist auch möglich und sei an dieser Stelle gleich erwähnt, daß der Bauelementträger für die Aufnahme solcher elektrischer Drosseln, was ein bevorzugtes Anwendungsgebiet vorliegender Erfindung ist, auch anders ausgebildet sein kann, wenn beispielsweise ein Kern ohne diese der Isolierung dienenden Kunststoffhalbschalen verwendet wird, der beispielsweise mit einem entsprechenden Isoliermaterial umsintert oder lackiert sein kann. In diesem Falle bedarf es des Aufnahmekanals 18 nicht; sollen andere Bauelemente montiert werden, sind natürlich die Aufnahmemittel und Räumlichkeiten im Bauelementträger 11 so zu beschaffen und auszubilden, daß diese elektrischen Bauelemente mit möglichst geringem Platzbedarf aufgenommen und sicher gehalten werden können. Es versteht sich dann auch, daß der Grundträger 10 der Bauform des Bauelementträgers, die sich an der Art des elektrischen Bauelements ausrichtet, anzupassen ist. Auf jeden Fall verfügt der Grundträger über die Rastmittel erster Art, also die Rastbeinchen-und der Bauelementträger 11 verfügt zusammen mit dem Grundträger 10 über Rastmittel zweiter Art, die zwei verschiedene Rastpositionen vorgeben können.

Bei dem dargestellten Ausführungsbeispiel sind diese Rastmittel zweiter Art mit 19 bezeichnet und umfassen nach unten, also in diesem Fall den Grundträger einschließende, ebenfalls um 120° über den Umfang versetzt angeordnete Stege 19a, 19b und 19c, die innen zueinander im Abstand angeordnete Rastausnehmungen 23 bilden, in welche ein Rastvorsprung 24 am Grundträger (siehe Fig. 1) eingreift.

Es versteht sich, daß Aufbau und Funktion dieser Rastmittel zweiter Art vollkommen beliebig sein können; sie müssen lediglich die Funktion erfüllen, daß die beiden Gehäuseteile Grundträger und Bauelementträger in zwei verschiedenen Höhenpositionen zueinander (bezogen auf den Abstand des Bauelemententrägers zur Leiterplatte) ineinander verrastet fixiert werden können.

Hierzu sind bei den in Fig. 3 gezeigten Stegen 19a die Ausnehmungen 23 in unterschiedlicher Höhe angeordnet, so daß in der ersten Rastposition, die in Fig. 6a dargestellt ist, der Rastvorsprung 24 in die untere Rastausnehmung 23 des Bauelementträgers 11 eingreift, während, wie ohne weiteres ersichtlich, durch eine entsprechende Druckeinwirkung auf den Bauelementträger bei mit der Leiterplatte schon verrasteten Grundträger der Rastvorsprung 24 in die zweite, obere Rastausnehmung jedes Steges 19a überspringt und sich hierdurch die in Fig. 6b dargestellte zusammengepreßte Gehäuseform ergibt. Gleichzeitig hiermit ergibt sich folgendes:

1. Entsprechend einem bevorzugten Ausführungsbeispiel ist der Rastvorsprung 24 auf der zur Rastnase 15 abgewandten Seite jedes Rastbeinchens 13a angeordnet, wie Fig. 1 zeigt, so daß auch die Stege 19a, 19b, 19c auf diese Rastbeinchen in ihrer umfangsmäßigen Orientierung ausgerichtet sind. Durch das Abwärtsgleiten in die zweite Rastposition der gegenseitigen Gehäuseverriegelung gelangen dabei die Stege 19, wie die Fig. 6a und 6b zeigen, hinter die jeweiligen Rastbeinchen 13 und füllen so den zunächst noch freien Raum in der Öffnung 25 der Leiterplatte 26 vollkommen aus, wobei die Teile in der zusammengepreßten Position der Fig. 6b jetzt, wie bei 27 erkennbar, jedenfalls in der Höhe der Leiterplattendurchbrechung formschlüssig und bündig aneinanderliegen. Ein Aushaken der Rastbeinchen 13 aus den Leiterplattendurchbrechungen ist daher ausgeschlossen.

Es versteht sich natürlich, daß die Verriegelungsmittel zweiter Art,bei den bisher besprochenen Figuren,gebildet von den Rastausnehmungen 23 und dem Rastvorsprung 24 auch an anderer Stelle angeordnet sein können, wo sie für die gegenseitige Verriegelung der beiden Gehäusehälften Grundträger und Bauelementträger in die beiden Rastpositionen nutzbar sind. Wesentlich ist aber, daß für die Verriege lung der Rastmittel erster Art, also der Rastbeinchen 13 die Stege 19, wie erläutert, hinter die Rastbeinchen zu drücken sind, so daß diese Stege gleichzeitig Arretierungsmittel für die Rastmittel erster Art bilden. Bei dem dargestellten Ausführungsbeispiel erfüllen die Stege 19 in der Verteilung der Stege 19a, 19b, 19c daher gleichzeitig zwei Aufgaben, sie tragen nämlich einmal die Rastmittel zweiter Art und sie bilden die Verriegelungsmittel für die Rastmittel erster Art am Grundträger.

2. Gleichzeitig mit diesem Zusammendrücken werden die elektrischen Anschlußdrähte des jeweiligen elektrischen Bauelements voll durch die Leiterplatte 26 gedrückt und für das Verlöten vorbereitet. Hierzu ist bei dem dargestellten Ausführungsbeispiel zunächst darauf hinzuweisen, daß nach Einlegen des Ringkerns 20 in den Aufnahmekanal 18 des Bauelementträgers 11 und nach Aufsetzen der Abdeckkappe 21 die so gebildete, aus zwei Halbschalen bestehende Ringform des Bauelementträgers mit der Drosselwicklung 22 umwickelt wird, wobei dann die Wicklungsenden in Haltekanäle 28 jeweils eingeführt werden, die als Bohrungen von über die Ringform des Gehäuses in diesem Fall vorspringenden Ansätzen 29 im Bauelementträger gebildet sind. Dabei können die elektrischen Anschlußdrähte in den Haltekanälen 28 auch soweit vorgeschoben werden, daß sie beim Zusammenbringen der beiden Gehäusehälften Grundträger und Bauelementträger bis in die Trichterform 17, die natürlich auf den Haltekanal 28 ausgerichtet ist, hineinragen, gegebenenfalls bis in den verjüngten Bereich 17a oder auch darüber hinaus, was wahlweise entschieden werden kann, beispielsweise auch von der Dicke und der Steifigkeit der Anschlußdrähte.

Anschließend wird dann das auf diese Art zunächst in der ersten auseinandergezogenen Verriegelungsposition miteinander verrastete Gesamtgehäuse aus Grundträger 10 und Bauelementträger 11, wie in Fig. 6 gezeigt, auf die Trägerplatte 26 aufgesetzt und die Rastmittel erster Art, also die Rastbeinchen 13 in den zugeordneten Ausnehmungen 25 der Trägerplatte 26 verrastet. Diese in Fig. 6a dargestellte erste Verrastungsposition der beiden Gehäuseteile Grundträger und Bauelementträger zueinander ist auch in vorteilhafter Weise der Lieferzustand.

Die in der Leiterplatte 26 angeordneten Durchtrittsbohrungen 30 für die elektrischen Anschlußdrähte der Bauelemente sind auf die Führungsmittelposition, gebildet von dem Haltekanal 28 und der Trichterform 17 ausgerichtet, so daß bei weiterem Zusammendrücken, also Überführen des Gehäuses in die zusammengedrückte Position der Fig. 6b, wie bei 31 gezeigt, nunmehr das Ende des elektrischen Anschlußdrahts über die Rückseite der Leiterplatte 26 im gewünschten Maße heraustritt. Hierdurch hat das Gehäuse für die elektrischen Bauelemente seine endgültige Verrastungs-und Endposition erreicht, die Rastmittel erster Art sind in ihren Aufnahmeöffnungen 25 der Leiterplatte 26 absolut verriegelt und die elektrischen Anschlußdrähte zur Verlötung vorbereitet.

Es versteht sich, daß, wie weiter vorn schon erwähnt, dieses dargestellte Ausführungsbeispiel nur eine von vielen Möglichkeiten realisiert, die der vorliegenden Erfindung innewohnen; so können beispielsweise die Rastmittel zweiter Art auch vollständig unterschiedlich ausgebildet und an anderer Stelle als die Arretierstege 19 angeordnet sein; es kann sich hier um aufeinander ausgerichtete Wandungshälften von Grundträger und Bauelementträger handeln, die eine sägezahnartige Struktur aufweisen, so daß beim Zusammendrücken die jeweiligen Sägezahnformen aneinander vorbeiratschen und in der gewünschten Endposition unverrückbar miteinander verbunden bleiben. Es ist auch möglich, die Rastmittel zweiter Art so auszubilden, daß in der ersten Ausgangsrastposition der beiden Gehäuseteile zueinander ein unter Druck erfolgendes Lösen der jeweiligen speziellen Rastvorsprünge und Rastausnehmungen in erleichterter Weise möglich ist, durch entsprechende Formgebung beispielsweise, während in der Endposition die Formgebung so getroffen ist, daß ein Lösen ausgeschlossen ist.

Die Darstellung der Fig. 5 zeigt in der perspektivischen Form ebenfalls auf der einen Hälfte der Mittellinie das Gehäuse für das elektrische Bauelement in der auseinandergezogenen Form und auf der anderen Seite in der zusammengedrückten Endposition.

Betrachtet man in diesem Zusammenhang numerische Werte, die die Erfindung allerdings nicht einschränken, dann kann im Lieferzustand das Gehäuse in der ersten Rastposition der zweiten Rastmittel um 2 bis 3 mm höher als in der zweiten Rastposition sein; bei der Montage wird der Bauelementträger nach dem Einführen der Rastbeinchen des Grundträgers in ihrer Verrastung mit der Leiterplatte heruntergedrückt, bis die zweite endgültige Verrastung, und falls gewünscht, auch die Verriegelungsposition der beiden Gehäusehälften erreicht ist. In diesem Zustand - schieben sich dann gleichzeitig die Anschlußdrähte durch die Bohrungen der Leiterplatte und die Verriegelungsstege hinter die Rastbeinchen. Es sei aber darauf hingewiesen, daß die Erfindung auch bei Realisierung nur einer dieser Maßnahmen selbstverständlich erfüllt ist, da man auch allein durch die Maßnahme etwa der Verriegelung der Rastbeinchen (bei dann anderweitiger Herstellung der elektrischen Verbindung) oder durch die Herstellung der elektrischen Verbindungen allein (bei dann entweder anderweitiger Verriegelung oder bei Belassen ursprünglicher Verrastungspositionen) die Erfindung realisiert und benutzt ist.

In der Darstellung der Fig. 7 ist eine andere Möglichkeit für die Führung und Positionierung der Anschlußdrähte des elektrischen Bauelements gezeigt, wobei auch hier wieder von der in den Fig. 1 bis 4 gezeigten Gehäusegrundform ausgegangen wird, mit einem unteren Grundträger 10' und dem Bauelementträger 11', die auf einer Leiterplatte 26' in der gezeigten Endposition befestigt sind. Es wird auch hier wieder von der Anordnung einer liegenden Drossel ausgegangen, deren Kern mit 20' und deren Wicklung bei dargestellten maximalem Wicklungsdurchmesser mit 22' bezeichnet ist. Das Kappenoberteil für die Kernisolierung ist nicht dargestellt; man erkennt die beiden Rastpositionen für die Rastmittel zweiter Art bei 32 und auch die Hintergreifung und Verriegelung der Rastbeinchen 13 durch die Arretierungsstege 19.

Unterschiedlich ist die Art der Führung der elektrischen Anschlußdrähte bei dieser Ausführungsform - und dies empfiehlt sich vorzugsweise für weniger steife Drähte dünneren Durchmessers, die auch nicht verzinnt sind (durch eine Verzinnung kann man eine Versteifung der Anschlußdrähte erreichen)-jeweils innerhalb von ineinander verschiebbar im entsprechenden Rastermaß angeordneter Hülsen. Diese Hülsen sind sowohl am Bauelementteil angeordnet und dort mit 32 bezeichnet und sind nach unten gerichtet, als auch am Grundträger, wo sie nach oben sich trichterförmig öffnend gerichtet und mit 33 bezeichnet sind. Die unteren Hülsen 33 nehmen die Endbereiche der oberen Hülsen 32 auch in der ersten Verriegelungsposition der beiden Gehäuseteile zueinander auf, so daß beim weiteren Zusammendrücken die Anschlußdrähte 34 problemlos in den inneren Hülsenbohrungen geführt und von den verjüngten Endbereichen der Hülse ausgerichtet auf die Leiterplattenöffnungen 25' in diese eingeführt werden können. Wie schon weiter vorn erwähnt, sind die Mündungen der Hülsenaustritte, die auf die Leiterplattenöffnungen 25' gerichtet sind, geringfügig kleiner oder enger als die Leiterplattenöffnungen, so daß beim Durchtritt der Anschlußdrähte 34 diese nicht blockiert oder zurückgehalten werden.

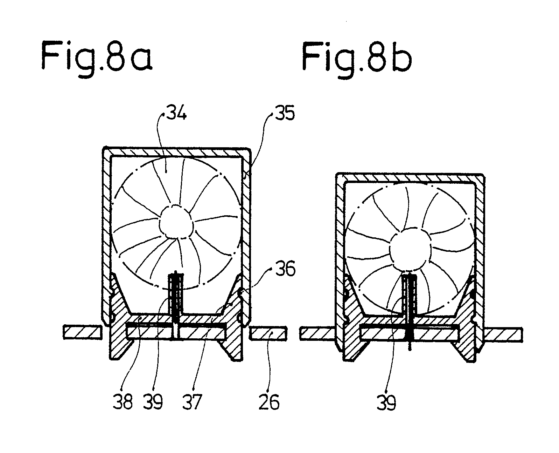

Es ist schon erwähnt, daß die Erfindung für jede Art von elektrischen Bauelementen, die mit einer Leiterplatte oder Printplatte zu verbinden sind, eingesetzt werden kann; bei den dargestellten Ausführungsformen sind (Entstör-)Drosseln als Beispiel gewählt, die durch die Erfindung sowohl liegend als auch stehend mit der Leiterplatte verbunden werden können. Ein mögliches Ausführungsbeispiel für eine stehende Montage von Spulen oder Drosseln 34 ist in den Fig. 8a und 8b gezeigt. Der Bauelementträger ist hier kastenförmig oder rechteckförmig mit allseitiger, jedoch unten offener Wandung ausgebildet und mit 35 bezeichnet; er weist an seiner Innenwandung bei 36 auf an hochgezogenen Wandungsteilen 37 des Grundträgers 38 angeordnete Rastausnehmungen ausgerichtete Rastvorsprünge 36 auf. Ferner sind beispielsweise beidseitig und die Spule 34 zwischen sich aufnehmend Anschlußdraht-Führungshälse 39 vorgesehen, die bei dieser Ausführungsform lediglich am Grundträger 38 angeordnet sind und in welche anfänglich die elektrischen Anschlußdrähte der Spule eingeführt werden. Da beim Niederdrücken des oberen Gehäuseteils, also des Bauelementträgers 35 die Spule nach unten mitgenommen wird, drücken sich auch deren elektrische Anschlußdrähte weiter durch den Führungshals 39 und durch die daraus ausgerichtete Öffnung in der Printplatte 26.

Die Darstellung der Fig. 8a und 8b soll insbesondere verdeutlichen, daß eine Vielzahl von unterschiedlichsten Lösungen unter Zugrundelegung des erfindungsgemäßen Grundgedankens möglich ist, zwei Bauteile mit unterschiedlichen Rastpositionen vorzugeben, wobei sich dann bei der Montage durch das Überführen in die endgültige Endrastposition der beiden Gehäuseteile die erwähnten Vorteile ergeben.

Eine weitere, unter bestimmten Umständen besonders vorteilhafte Ausgestaltung vorliegender Erfindung besteht darin, daß der zweite Verrastungsvorgang, durch welchen die beiden Gehäuseteile aus der Vorrastposition in die Endrastposition überführt werden, in sich nochmals unterteilt wird bzw. daß an den mit den ersten Verrastungsmitteln durchgeführten Verrastungsschritt des Gehäuses mit der Print-oder Leiterplatte noch ein zweiter Verrastungsteilschritt angehängt wird.

Diese Ausgestaltung vorliegender Erfindung beruht auf der Erkenntnis, daß insbesondere bei - schwereren elektrischen Bauelementen die Verrastungsmittel erster Art, also die Rastbeinchen mit Verriegelungsnase für die Print-oder Leiterplatte vergleichsweise kräftig auszuführen sind, so daß sich bei entsprechend angepaßten Schlitzen oder Durchbrechungen der Leiterplatte eine gewisse Schwergängigkeit beim Eindrücken der Rastbeinchen ergeben kann. Die Erfindung sieht daher hier vor - und die Anwendung versteht sich selbstverständlich als besonders geeignet für beliebige elektrische Bauelemente, also nicht nur solche - schwererer Ausführung -, daß die Anfangsdurchbrechungen in der Leiterplatte mit hinreichend großem Spiel ausgeführt werden, so daß man die Verrastungsmittel erster Art (Rastbeinchen 13) einfach durch die entsprechenden Primäröffnungen der Leiterplatte einführen und hindurchstecken kann. Der weitere Verrastungsablauf ist dann so, daß das ganze Gehäuse um einen vorgegebenen Winkelbetrag gedreht wird, entweder im Uhrzeigersinn oder im Gegenuhrzeigersinn, wobei die jeweils zurückgelegte Wegstrecke mindestens gleich sein sollte der Breite jedes Rastbeinchens 13 (in der Zeichnung nicht dargestellt). Durch diese Drehbewegung gelangen nämlich die Rastbeinchen in einen verengten oder verjüngten Teilbereich der Leiterplattenausnehmung, der sich, ausgehend von der Primäröffnung, natürlich in der Drehrichtung erstreckt, also theoretisch kreiswinkelförmig verläuft, was jedoch bei der nur geringen Drehbewegungen bei der Bemessung der Leiterplattendurchbrechungen nicht notwendigerweise zum Ausdruck zu kommen braucht. Man erkennt, daß durch das Verdrehen und das hierdurch sich ergebende Einfahren der Rastbeinchen in einen wesentlich verengten Durchbrechungsbereich jedes Rastbeinchens nach vorn und hinten, also in der Querrichtung, in welcher sich auch seine Rastnase erstreckt, völlig fest in der entsprechenden Leiterplattendurchbrechung sitzt, und zwar deshalb, weil die in Drehrichtung weiterführende Öffnung in der Leiterplatte, ausgehend von der Primäröffnung, nur so breit ist, wie auch das zugehörige Rastbeinchen, welches daher nach der Verdrehung in dieser Öffnung bündig sitzt.

Man erkennt hier auch einen weiteren Vorteil, der sich durch diese Ausgestaltung ergibt; durch das erleichterte Einführen der Rastbeinchen als Verriegelungsmittel erster Art in die mit größerer Toleranz bemessenen Primäröffnungen der Leiterplatte braucht nicht ein so großer Druck ausgeübt zu werden, daß unter Umständen schon die Verrastungsmittel zweiter Art ansprechen, jedenfalls braucht hierauf nicht bei der Montage geachtet zu werden.

Allerdings ist es erkennbar, daß eine Rückwärtsdrehbewegung jedenfalls zunächst nicht ausgeschlossen ist, so daß diese Ausgestaltung vorliegender Erfindung das weitere Merkmal beinhaltet, daß nach dem Verdrehen bis auf eine vorgegebene Anschlagwinkelposition, in welcher dann auch die Durchfädelöffnungen für die elektrischen Anschlußdrähte in der Leiterplatte genau ausgerichtet sind auf die entsprechenden Hülsenführungen bzw. überhaupt Hilfsführungsmittel für die Anschlußdrähte, der weitere Montagevorgang dann wieder so abläuft, wie weiter vorn erläutert. Mit anderen Worten, es wird nach Erreichen der Anschlagdrehposition der Druck auf die beiden Gehäuseteile ausgeübt, so daß diese ineinanderrasten und die Endrastposition erreichen, hier lediglich mit der Maßgabe, daß die hierbei nach unten in ihre Verriegelungsposition gelangenden Verriegelungsstege vom zweiten Gehäuseteil, also vom Elementträger nicht hinter die Rastbeinchen als Verriegelungsmittel erster Art gelangen, sondern seitlich neben diese und so den sich durch die Verdrehung ergebenden Freiraum (Primäröffnung) in der Leiterplatte ausfüllen. Hierdurch wird es den Rastbeinchen und insgesamt dem Gehäuse unmöglich gemacht, sich unter Umständen willkürlich wieder in die ursprüngliche Ausgangswinkelposition zurückzudrehen.

Die restlichen Funktionsabläufe mit Bezug auf das Ein-und Durchfädeln der elektrischen Anschlußdrähte erfolgen dann bzw. laufen dann so ab, wie weiter vorn ausführlich erläutert und hieran hat sich ja auch durch die im zeitlichen Ablauf vorher liegende, noch durchzuführende Verdrehung nichts geändert, lediglich natürlich mit der Maßgabe, daß die Durchtrittsöffnungen für die elektrischen Anschlußdrähte jetzt in der Endanschlag-Winkelposition nach Verdrehung des Gesamtgehäuses auf die Führungsmittel für die Anschlußdrähte ausgerichtet sind.

Alle in der Beschreibung, den nachfolgenden Ansprüchen und der Zeichnung dargestellten Merkmale können sowohl einzeln als auch in beliebiger Kombination miteinander erfindungswesentlich sein.

## Ansprüche

1. Verfahren zur Lagerung von elektrischen Bauelementen (Spulen, (Entstör)Drosseln, Übertrager, Kondensatoren, Transistoren, Chips u.dgl.) auf einer Leiterplatte oder Printplatte o.dgl., wobei ein das Bauelement tragendes oder aufnehmendes, ferner Rastmittel (Rastbeinchen) erster Art aufweisendes Gehäuse dadurch mit der Leiter-oder Printplatte verankert wird, daß das Gehäuse so weit auf die Printplatte aufgeschoben wird, bis durch Öffnungen in dieser die Rastmittel erster Art mit Vorsprüngen die Leiter-oder Printplatte hintergreifen, dadurch gekennzeichnet, daß durch weitere Druckausübung auf das aus zwei relativ zueinander über Ratmittel zweiter Art beweglichen Gehäuseteilen (Grundträger 10, Bauelementträger 11) bestehende Gehäuse dieses ineinandergreifend zusammengedrückt und dabei gleichzeitig das zweite Gehäuseteil (Bauelementträger 11) näher an die Leiterplatte (25, 25') herangebracht und die erreichte Endposition durch an den Gehäuseteilen befindliche Rastmittel zweiter Art gesichert wird.

2. Verfahren nach Anspruch 1, dadurch gekennzeichnet, daß durch das Ineinanderschieben der beiden Gehäuseteile Grundträger (10) und Bauelementträger (11) vom Bauelementträger (11) ausgehende Verriegelungsmittel (Verriegelungsstege) in die Durchtrittsöffnungen (25) der Leiter-oder Trägerplatte (26) und hinter die Verriegelungsmittel erster Art (Rastbeinchen 13) geschoben werden.

3. Verfahren nach Anspruch 1 oder 2, dadurch gekennzeichnet, daß durch das Ineinanderschieben der beiden Gehäuseteile Grundträger (10) und Bauelementträger (11) vom Bauelementträger (11) ausgehende elektrische Anschlußdrähte (34) des jeweiligen Bauelements, ausgerichtet auf entsprechend angeordnete Durchtrittsöffnungen (30, 25') in der Printplatte (26, 26') in diese Durchtrittsöffnungen ein-und durch diese hindurchgeschoben werden derart, daß ein entsprechend überstehender Restabschnitt auf der anderen Leiterplattenseite verlötet werden kann.

4. Verfahren nach Anspruch 1, dadurch gekennzeichnet, daß sich unmittelbar an das Einsetzen der Rastmittel erster Art (Rastbeinchen 13) in die Leiterplattendurchbrechungen eine Verdrehbewegung des gesamten Gehäuses aus Grundträger (10) und Bauelementträger (11) anschließt, durch welche die Rastmittel erster Art (Rastbeinchen 13) bis zu einem vorgegebenen Anschlag in sich an die Primärdurchführungsöffnungen der Leiterplatte seitlich anschließende und sich hierbei verjüngende oder verengende Zusatzöffnungen gelangen.

5. Verfahren nach Anspruch 4, dadurch gekennzeichnet, daß die Zusatzöffnungen so bemessen sind, daß sie jedes in sie durch die Verdrehbewegung des Gehäuses eingeschobene Rastbeinchen (13) von vorn und hinten bündig erfassen.

6. Verfahren nach Anspruch 4 oder 5, dadurch gekennzeichnet, daß der Verdrehanschlag für die Rastbeinchenarretierung so bemessen ist, daß sich hierdurch die erforderliche Ausrichtung der die Anschlußdrähte aufnehmenden Öffnungen der Leiterplatte mit Bezug auf die Anschlußdraht-Führungsmittel ergeben.

7. Verfahren nach einem der Ansprüche 4 bis 6, dadurch gekennzeichnet, daß durch die sich nach der Verdrehbewegung ergebenden relativen Einrastbewegungen der beiden Gehäuseteile (Grundträger 10, Bauelementträger 11) ineinander seitlich neben die in den Zusatzöffnungen der Leiterplatte auf Anschlag liegenden Rastbeinchen (13) Arretierstege schieben, die die anfängliche Primäröffnung in der Leiterplatte ausfüllen und eine in Gegenrichtung verlaufende Drehbewegung verhindern.

8. Verfahren nach Anspruch 7, dadurch gekennzeichnet, daß die Arretierstege am Bauelementträger (11) (einstückig) befestigt sind und sich durch die weitere Druckausübung und die relativ zueinander und ineinader erfolgende Bewegung der beiden Gehäuseteile zueinander nach unten in die Primäröffnungen absenken.

9. Vorrichtung zur Lagerung von elektrischen Bauelementen (Spulen, (Entstör)Drosseln, Übertrager, Kondensatoren, Transistoren, Chips u.dlg.) auf einer Leiterplatte, Printplatte o.dgl., mit einem das Bauelement tragenden oder aufnehmenden Gehäuse, welches über Rastmittel erster Art (Rastbeinchen) an der Printplatte verankert ist, zur Durchführung des Verfahrens nach einem der Ansprüche 1 bis 8, dadurch gekennzeichnet, daß das Gehäuse aus zwei zueinander relativ beweglichen Teilen (10, 11) besteht, daß ein erstes Gehäuseteil aus einem mit der Leiterplatte (26, 26') verrastbaren Grundträger (10) mit einer vorgegebenen Anzahl von Rastbeinchen (13, 13a, 13b, 13c) besteht, die mit Vorsprüngen (15) die abgewandte Leiterplattenseite hintergreifen, daß der zweite Gehäuseteil (11) als das elektrische Bauelement aufnehmender oder tragender Bauelementträger ausgebildet ist und daß zwischen Grundträger (10) und Bauelementträger (11) Rastmittel (23, 24) zweiter Art vorgesehen und so ausgebildet sind, daß die beiden Gehäuseteile (Grundträger 10, Bauelementträger 11) eine erste Vorrastposition (zur Montage und Lieferung) und eine zweite Endrastposition einnehmen, in welcher der Bauelementträger (11) sich näher an der Leiterplatte (26, 26') befindet.

10. Vorrichtung nach Anspruch 9, dadurch gekennzeichnet, daß in der zweiten Endrastposition der beiden Gehäuseteile (Grundträger 10, Bauelementträger 11) vom Bauelementträger (11) ausgehende Verriegelungsstege (19, 19a, 19b, 19c) in verbliebene Freiräume der die Rastmittel erster Art (Rastbeinchen 13) aufnehmenden Öffnungen (25) der Leiterplatte (26, 26') eingeführt sind und die Rastmittel erster Art in dieser Position arretieren.

11. Vorrichtung nach Anspruch 9 oder 10, dadurch gekennzeichnet, daß bei ineinandergeschobener Endrastposition der beiden Gehäuseteile (Grundträger 10 und Bauelementträger 11) vom Bauelementträger (11) ausgehende elektrische Anschlußdrähte des jeweils gelagerten elektrischen Bauelements durch zugeordnete und auf Führungsmittel (28, 17, 17a) im Grundträger (10) und/oder Bauelementträger (11) für die Anschlußdrähte ausgerichtete Durchtrittsöffnungen (30, 25') in der Leiterplatte (26, 26') geführt sind.

12. Vorrichtung nach einem der Ansprüche 9 bis 11, dadurch gekennzeichnet, daß die Rastmittel erster Art (Rastbeinchen 13, 13a, 13b, 13c) am Grundträger (10) gleichzeitig auch den zugeordneten Teil (Rastvorsprung 24) der Rastmittel zweiter Art aufweisen, derart, daß der andere Teil (Rastausnehmungen 23) der Rastmittel zweiter Art am anderen Gehäuseteil (Bauelementträger 11) an Stegen (19, 19a, 19b, 19c) angeordnet sind, die gleichzeitig durch ihre Form Verriegelungsstege für die hintere Abstützung der Rastmittel erster Art (Rastbeinchen 13) sowie das Auffüllen der Durchtrittsöffnungen in der Printplatte (26, 26') bilden.

13. Vorrichtung nach einem der Ansprüche 9 bis 12, dadurch gekennzeichnet, daß die Rastmittel zweiter Art zur Verrastung der beiden Gehäuseteile (Grundträger 10 und Bauelementträger 11) gegeneinander in zwei möglichen Rastpositionen (Lieferzustand und Montageendzustand) von Rastvorsprüngen (24) an einem Gehäuseteil und so vielen Rastausnehmungen (23) am anderen Gehäuseteil gebildet sind, wie gewünschte unterschiedliche Rastpositionen der Gehäuseteile zueinander einzunehmen sind.

14. Vorrichtung nach einem der Ansprüche 9 bis 12, dadurch gekennzeichnet, daß die Rastmittel zweiter Art an einander zugewandten Wandteilen der beiden Gehäuseteile angeordnet sind und die Form von inenander jeweils rastenden Sägezahnflächen aufweisen.

15. Vorrichtung nach einem der Ansprüche 9 bis 14, dadurch gekennzeichnet, daß die elektrischen Anschlußdrähte in mindestens am Bauelementträger (11) angeordneten Haltekanäle (28) geführt sind.

16. Vorrichtung nach einem der Ansprüche 9 bis 15, dadurch gekennzeichnet, daß die Haltekanäle (28) auf Durchtritts-Führungsöffnungen (17, 17a) im darunter angeordneten Grundträger (10) ausgerichtet sind.

17. Vorrichtung nach Anspruch 16, dadurch gekennzeichnet, daß die Durchtritts-Führungsöffnung (17, 17a) im Grundträger (10) kegelförmig in Richtung auf die Durchtrittsöffnung in der zugeordneten Leiterplatte verjüngend ausgebildet ist.

18. Vorrichtung nach einem der Ansprüche 9 bis 14, dadurch gekennzeichnet, daß zur Führung der (verzinnten) Anschlußdrähte ineinander verschiebbare Hülsen (32, 33) am Träger teil (10) und Bauelementteil (11) vorgesehen sind, wobei das Ende der jeweils auf die Durchtrittsöffnung (31, 25') ausgerichteten unteren Hülse unmittelbar auf der Printplatte oder der Leiterplatte (26, 26') aufsitzt und trichterförmig ausgebildet ist.

19. Vorrichtung nach Anspruch 18, dadurch gekennzeichnet, daß der Enddurchmesser des Trichters geringfügig kleiner als der Bohrungsdurchmesser der Durchtrittsöffnugnen für die elektrischen Anschlußdrähte in der Print-oder Leiterplatte ist, derart, daß der jeweilige Anschlußdraht beim Ineinanderschieben der Drahtführungshilfen aus dem Trichter heraus sich durch die Öffnung in der Printplatte auf die gewünschte Austrittslänge herausschiebt.

20. Vorrichtung nach einem der Ansprüche 9 bis 19, dadurch gekennzeichnet, daß vom Bauelementträger (11) ausgehende Verriegelungsstege so ausgebildet und angeordnet sind, daß sie in der zweiten Endrastposition der beiden Gehäuseteile sich seitlich an in verjüngte Leitungsplattendurchbrechungen eingedrehte Rastmittel erster Art (Rastbeinchen 13) unter Ausfüllen einer der Einführung der Rastbeinchen (13) dienenden Leiterplatten-Primäröffnung anlegen und das Gehäuse hierdurch gleichzeitig gegen eine Rückdrehbewegung verriegeln.

21. Vorrichtung nach Anspruch 20, dadurch gekennzeichnet, daß die die Rastbeinchen (13) des ersten Gehäuseteils (Grundträger 10) aufnehmenden Leiterplattenöffnungen in einer Querrichtung sich verjüngende einer Kreisbogenform folgende Verlängerungen aufweisen.

0 264 840

Fig.1

Fig.2

Fig.3

# Fig.4

# Fig.5

# Fig.6a

# Fig.6b

0 264 840

# Fig.7

0 264 840

# Fig.8a

# Fig.8b